# EUROPEAN PATENT SPECIFICATION

(11) **EP 2 351 078 B1**
(45) Date of publication and mention of the grant of the patent: **19.02.2020**
(21) Application number: 09741552.5
(22) Date of filing: 23.10.2009
(51) Int. Cl.: H01L 23/522, H01L 49/02, H01L 27/08, H01L 27/02

(54) **SHIELDING FOR INTEGRATED CAPACITORS**
ABSCHIRMUNG FÜR INTEGRIERTE KONDENSATOREN
BLINDAGE POUR CONDENSATEURS INTÉGRÉS

(30) Priority: 21.11.2008 US 276289; 21.11.2008 US 276291
(43) Date of publication of application: 03.08.2011
(73) Proprietor: Xilinx, Inc., San Jose, California 95124 (US)
(72) Inventor: QUINN, Patrick J., San Jose CA 95124 (US)
(74) Representative: Gibbs, Richard
(86) International application number: PCT/US2009/061955
(87) International publication number: WO 2010/059335

(56) References cited:
- DE-A1- 10 046 910
- US-A- 6 066 537
- US-A1- 2007 278 551
- US-B1- 6 737 698
- US-B1- 6 903 918
- US-B2- 7 259 956
- ROBERTO APARICIO ET AL: "Capacity Limits and Matching Properties of Integrated Capacitors", IEEE JOURNAL OF SOLID-STATE CIRCUITS, IEEE SERVICE CENTER, PISCATAWAY, NJ, USA, vol. 37, no. 3, March 2002 (2002-03), XP011061701, ISSN: 0018-9200

## Description

### FIELD OF THE INVENTION

The present invention relates to capacitors formed in integrated circuits ("ICs") commonly referred to as integrated capacitors.

### BACKGROUND

Methods of fabricating ICs typically include a front-end sequence of processing, in which various electrical devices such as transistors are formed in a semiconductor substrate, and a back-end sequence of processing, generally including forming alternating layers of dielectric material and patterned conductive material (typically metal) with conductive vias or other techniques being used to interconnect the metal layers to form a three-dimensional wiring structure that connects electrical devices to other electrical devices and to terminals of the IC.

Capacitors are used in IC systems for a variety of purposes. In many instances, it is desirable to incorporate (integrate) a capacitor in the IC chip. A simple approach is to form two conductive plates with an intervening dielectric; however, this consumes a relatively large area for the capacitance obtained. One technique for increasing the capacitance of a given area is to use multiple conductive plates, each conductive plate separated from the proximate plate(s) by dielectric. Further techniques use conducting strips, also called conductive lines, conductive fingers, or conductive traces, that are alternately connected to the first and second capacitor terminals (nodes). Sidewall coupling between the conductive strips provides capacitance. Layers of conducting strips, either offset or arranged in vertical congruency, can be added to further increase the capacitance of an integrated capacitor structure.

One capacitor has a number of conductive strips in successive layers connected to the first node alternating with an equal number of conductive strips connected to the second node of the integrated capacitor. The conductive strips are offset a half cell on successive layers, so that a conductive strip connected to the first node has conductive strips connected to the second node above and on both sides of it. Providing an equal number of conductive strips in a layer for each node balances the coupling of each node to the substrate, which is desirable in some applications, but undesirable in others, such as switching applications where it is desirable to have less coupling at one node. In order to reduce coupling to the substrate, a thick layer of silicon dioxide is used between the substrate and the first layer of conductive strips. This may be difficult to integrate in a standard CMOS fabrication sequence and might require additional steps to be added to the standard process flow. The overlapping parallel conductive strips are connected at their ends using buss strips that consume additional surface area.

Another approach to providing an integrated capacitor is to have conductive strips in a layer connected to alternate nodes of the capacitor with overlapping conductive strips connected to the same node. This forms essentially a curtain of conductive strips and interconnecting vias connected to the first node of the capacitor with adjacent curtains of conductive strips and interconnecting vias connected to the second node. Overlapping conductive strips connected to the same node avoids the lost surface area associated with buss strips; however, inter-layer capacitance is reduced because the upper strip is connected to the same node as the lower strip. This effect is somewhat obviated because, as critical dimensions shrink, inter-strip capacitance becomes more dominant than inter-layer capacitance. In other words, the dielectric layer separation between successive metal layers becomes increasingly greater than the dielectric separation between conductive strips with decreasing critical dimension.

Conventional integrated capacitors are often susceptible to electronic noise, which can affect the performance of the IC. In some applications, such as a filter capacitor application where one of the capacitor nodes (typically the bottom node) is connected to ground or to a power supply voltage, some degree of noise is often tolerable. However, in other applications, such as when the capacitor is used in a signal path (i.e., as a coupling capacitor or a switched capacitor), noise coupling can seriously degrade the performance of the circuit. Noise coupled onto a capacitor are particularly problematic when very low analog voltages are coupled through the capacitor, especially in a system on a chip, which often produce more electrical noise than other types of ICs, such as a memory chip. Thus, integrated capacitors providing better noise immunity are desired for used low-noise applications on an IC.

Patent application publication DE 100 46 910 A1 (Mitsubishi) describes semiconductor device comprising a lower layer with a main surface and a capacitor formed on the main surface of the lower layer. The capacitor has a line and intermediate space structure in which metal lines are electrically connected by an insulating layer. The lines extend in a first direction of the main surface and are arranged in a second direction, vertical to the first direction. Preferred Features: The line and intermediate space structure has a first line acting as an electrode and a second line acting as another electrode, the first and second lines being alternately arranged.

Patent application publication US 2007/278551 A1 (Anthony) describes an interdigitated Metal-Insulator-Metal (MIM) capacitor that provides self-shielding and accurate capacitance ratios with small capacitance values. The MIM capacitor includes two terminals that extend to a plurality of interdigitated fingers separated by an insulator. Metal plates occupy layers above and below the fingers and connect to fingers of one terminal. As a result, the MIM capacitor provides self-shielding to one terminal. Additional shielding may be employed by a series of additional shielding layers that are isolated from the capacitor. The self-shielding and additional shielding may also be implemented at an array of MIM capacitors.

United States Patent US 7 259 956 B2 (Fong et al.) describes several scalable integrated circuit high density capacitors and their layout techniques. The capacitors are scaled, for example, by varying the number of metal layers and/or the area of the metal layers used to from the capacitors. The capacitors use different metallization patterns to form the metal layers, and different via patterns to couple adjacent metal layers. In embodiments, optional shields are included as the top-most and/or bottom-most layers of the capacitors, and/or as side shields, to reduce unwanted parasitic capacitance.

United States Patent US 6 737 698 B1 (Paul et al) describes a method and apparatus of provided for shielding a capacitor structure formed in a semiconductor device. In a capacitor formed in an integrated circuit, one or more shields are disposed around layers of conductive strips to shield the capacitor. The shields confine the electric fields between the limits of the shields

United States Patent us 6 903 918 b1 (Brennan) describes a shielded planar capacitor structure, formed within a Faraday cage in an integrated circuit device. The capacitor structure reduces parasitic capacitances within the integrated circuit device. The capacitor comprises a capacitor stack formed between first and second metal layers of the integrated circuit. The capacitor stack has a first conductive layer formed from a third metal layer disposed between the first and second metal layers of the integrated circuit, a dielectric isolation layer disposed upon the first conductive layer; and a second conductive layer disposed upon the dielectric isolation layer and overlying the first conductive layer. The structure further has a first and second isolation layers disposed upon opposite sides of the capacitor stack. The Faraday cage is formed between the first and second metal layers of the integrated circuit, comprising a first and second shield layers each having a plurality of mutually electrically conductive spaced apart traces. The first and second isolation layers and the capacitor stack are sandwiched between the first and second shield layers. Conductive elements are distributed around the periphery of the capacitor stack and the first and second isolation layers. The conductive traces of the first shield layer are connected to the conductive traces of the second shield layer through the conductive elements.

"Capacity Limits and Matchin Properties of Integrated Capacitors", (Robertso Aparicio et al., published in the IEEE Hournal os Solid-State Circuits, Volumne 37, No. 3, March 2002, describes the derivation of theoretical limits for the capacitance density of integrated capacitors with combined lateral and vertical field components. These limits are used to investigate the efficiency of various capacitive structures such as lateral flux and quasifractal capacitors. This study leads to two new capacitor structures with high lateral-field efficiencies. These new capacitors demonstrate larger capacities, superior matching properties, tighter tolerances, and higher self-resonance frequencies than the standard horizontal parallel plate and previously reported lateral-field capacitors, while maintaining comparable quality factors. These superior qualities are verified by simulation and experimental results.

United States Patent US 6 066 537 A (Poh) describes a multilevel capacitor structure compatible with CMOS processing for use in switched capacitor circuits is disclosed. The capacitor structure has an associated parasitic capacitor which is placed in such a way so as to minimize the impact on the performance of a the switched capacitor circuit. The parasitic capacitor is formed between a first plate of the shielded capacitor and a diffusion well within a substrate. The diffusion well is connected to a quiet voltage reference source to isolate the shielded capacitor from noise present on the substrate. The shielded capacitor has a first plate that is fabricated from a first conductive material such as polycrystalline silicon or polycide, a second plate fabricated from a second conductive material such as a first level of metal on an integrated circuit, and a third capacitor plate fabricated from a second level of metal of an integrated circuit. The first plate and the third plate are connected to give a total capacitance given by the sum of capacitances between the first plate and second plate and between the second plate and third plate.

### SUMMARY

A capacitor in an integrated circuit ("IC") includes a core capacitor portion having a first plurality of conductive elements electrically connected to and forming part of a first node of the capacitor formed in a first conductive layer of the IC and a second plurality of conductive elements electrically connected to and forming a first part of a second node of the capacitor formed in the first conductive layer. The first plurality of conductive elements alternates with the second plurality of conductive elements in the first conductive layer. A third plurality of conductive elements electrically connected to and forming a second part of the first node is formed in a second conductive layer adjacent to the first conductive layer, at least portions of some of the second plurality of conductive elements overlying and vertically coupling to at least portions of some of the third plurality of conductive elements, wherein the first plurality of conductive elements comprises a first plurality of conductive strips extending in a first direction, the second plurality of conductive elements comprises a second plurality of conductive strips extending in the first direction, and the third plurality of conductive elements comprises a third plurality of conductive strips extending in a second direction orthogonal to the first direction. The capacitor also includes a shield capacitor portion having a fourth plurality of conductive elements formed in each layer between a third conductive layer of the IC and a fourth conductive of the IC including at least the first conductive layer of the IC, the second conductive layer of the IC, the third conductive layer of the IC, and the fourth conductive layer of the IC, the first conductive layer (M3) and the second conductive layer each being between the third conductive layer and the fourth conductive layer. The shield capacitor portion is electrically connected to and forms part of the second node of the capacitor and surrounds the first plurality of conductive elements and third plurality of conductive elements, wherein elements of the fourth plurality of conductive elements in the first and second metal layers extend in the first direction; a reference shield electrically connected to a reference node (V_{DD}) of the IC other than the second node of the capacitor, the shield capacitor portion being disposed between the reference shield and the core capacitor portion, wherein the reference shield includes an N-well of a substrate of the IC, a first conductive curtain extending from the N-well, and a second conductive curtain extending from the N-well; and a second reference shield comprising a ground shield and conductive curtains extending from a substrate portion and connected to an analog ground of the IC, the reference shield being disposed between the second reference shield and the shield capacitor portion; and wherein the N-well and the substrate portion are formed in a moat.

### BRIEF DESCRIPTION OF THE DRAWINGS

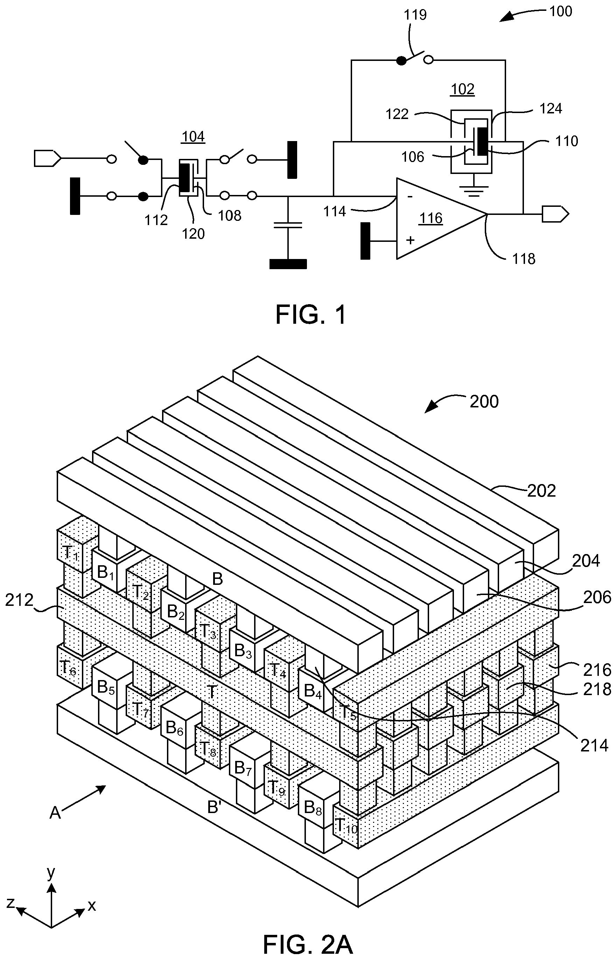

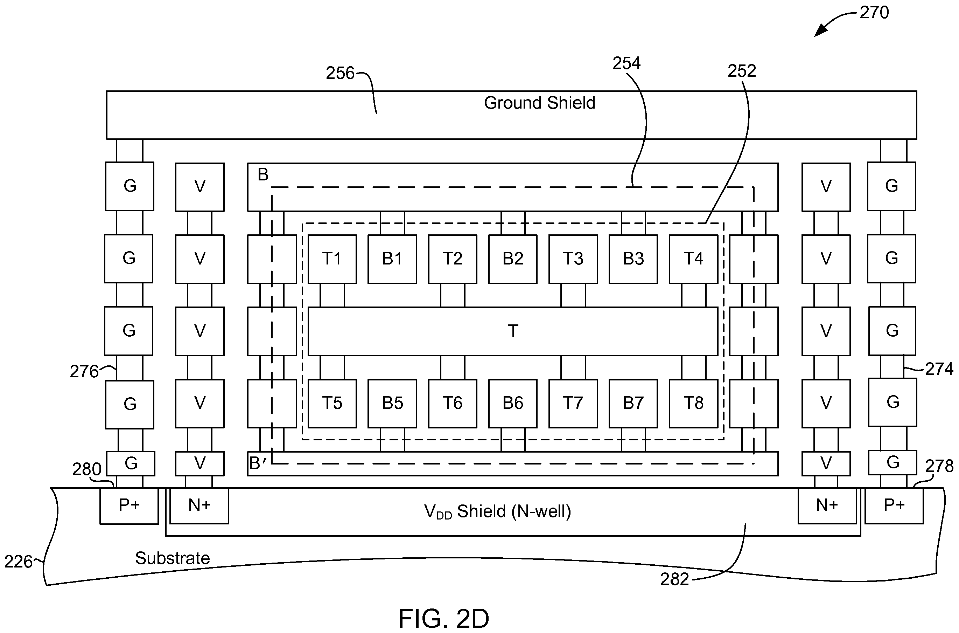

Accompanying drawings show examples to assist the reader in understanding one or more aspects of the invention; however, the accompanying drawings should not be taken to limit the invention to the examples shown, but are for explanation and understanding only. Figure 2D shows a capacitor with two reference shields as defined in the independent claim. The integrated capacitors of figures 2A-2C, 3A and 4A are not part of the claimed invention, but useful for its understanding.
FIG. 1 is a circuit diagram of a circuit using capacitors.
FIG. 2A is an isometric view of a portion of a shielded integrated capacitor.
FIG. 2B is a side view of an integrated capacitor 220 in accordance with FIG. 2A.
FIG. 2C is a side view of the integrated capacitor according to FIG. 2A with a ground shield.
FIG. 2D is a side view of the integrated capacitor according to FIG. 2A with an alternative ground shield.
FIG. 3A is a side view of an integrated capacitor with a bottom node shield.
FIG. 3B is a partial cutaway plan view of the M5 and M4 layers showing a portion of the ground plate and underlying bottom node shield plate of FIG. 3A.
FIG. 4A is side view of an integrated capacitor with a bottom node shield.
FIG. 4B is a cross section of a shielded integrated thin-dielectric capacitor in an IC,
FIG. 5 is a plan view of an FPGA incorporating an integrated capacitor.

### DETAILED DESCRIPTION

FIG. 1 is a circuit diagram of a circuit 100 using capacitors 102, 104 . The top node 108 of capacitor 104 is switchable to be connected to or disconnected from a high-impedance input 114 of amplifier 116. The top node 106 of the feedback capacitor 102 is also connected to the high-impedance input 114 of the amplifier 116 while the bottom node 110 is connected to output 118 of the amplifier 116. The feedback capacitor 102 is switchably shorted by closing switch 119. The coupling capacitor 104 has a top node 108 shielded by a bottom node shield 120 that essentially surrounds the top node 108 with conductive structures electrically connected to the bottom node and reduces parasitic capacitive coupling of the top node 108 to other nodes of the circuit 100. Connection to the top node 108 is made through a gap in the bottom node shield 120. Although the bottom node shield is shown as being contiguous, in some embodiments the bottom node shield is made up of several conductive elements, such as metal filaments, metal vias, and polysilicon or suicide plates or strips, to form a conductive cage around the top node, shielding the top node from electronic noise and from coupling to other nodes of the IC. In some embodiments, the bottom node shield contributes to the overall capacitance of the integrated capacitor by coupling to the top node. Note that a capacitor is generally thought of as a two terminal device, and the "top" and "bottom" nodes as described herein generally correspond to these two terminals of the capacitor. Thus, the structures described below may be thought of as connecting (e.g., electrically) to one or the other node, or forming portions or parts of a node. A node is not separate from the capacitive structures connected to it, but those structures may form portions of a node.

The feedback capacitor 102 has a top node 110 shielded by a bottom node shield 122, and by an optional reference shield 124. The reference shield 124 is connected to a relatively stable reference voltage present in the IC, such as analog ground, digital ground, or V_{DD}. The reference shield 124 essentially surrounds the bottom node shield 120 and shields the bottom node from substantially coupling to more than one voltage reference (e.g., the bottom node couples to V_{DD} or ground, but not both). In other embodiments, a reference shield partially surrounds a bottom node shield. The reference shield has a gap allowing electrical contact to be made to the bottom node, as described above.

The terms "top" node and "bottom" node do not necessarily relate to the physical orientation of the nodes relative to the IC or other structure, but are used as terms of convenience. In some circuit applications, the top node of a capacitor indicates the node that is connected to a high-impedance or high-gain port of an amplifier or other device. In a system-on-chip ("SoC"), the accuracy on an analog-to-digital converter ("ADC") is dependent on the ratio of the parasitic capacitance at the top node (Cₜₒₚ) to all other nodes except the bottom node and the capacitance (C_{sig}) that is the useful floating signal capacitance between both nodes. It is desirable to shield the top plate from ground currents or voltage supply fluctuations so that Cₜₒₚ remains low. Using the bottom node to essentially surround the top node isolates the top node from coupling with other nodes in the circuit by essentially forming a portion of Faraday shell around the top node, and in some embodiments, distancing the top node from other conductive elements in the IC. It is understood by those of skill in the art that electrical connection to the top node is made through the bottom node shield, and therefore the bottom node shield does not completely surround the top node.

In some embodiments, some sides of the top node are left unshielded. For example, an end of the top node that is physically distant from other nodes might be left unshielded. In other embodiments, integrated capacitors are used as design cells, and adjacent integrated capacitors are connected in parallel to obtain a higher total capacitance. In some embodiments, the portions of the bottom node shield of adjacent commonly-connected integrated capacitors are omitted, allowing higher packing density.

Complex ICs, such as programmable logic devices, often have several patterned metal layers separated by layers of dielectric material formed over a semiconductor substrate that are used for wiring connections and other functions commonly called the "backend" of the IC. Some embodiments of the invention are adaptable to existing CMOS process sequences by using masks that form the desired patterns in the appropriate metal layers and vias through the inter-metal dielectric ("IMD") layers or inter-layer dielectric ("ILD") in the backend of the IC. The vias are formed using any of several known techniques, such as contact plug, damascene, or dual damascene techniques. Similarly, the conductive strips are formed using any of several known techniques, such as thin-film metal etch, thin-film metal lift-off, damascene, and dual damascene techniques. In some embodiments, one of the conductive layers is a polysilicon or suicide layer. In a further embodiment, a conductive well in the semiconductor substrate forms a portion of a capacitor plate or a shield.

FIG. 2A is an isometric view of a portion 200 of an integrated capacitor. A bottom plate conductive matrix 202 includes a first bottom plate layer B made up of a first plurality of conductive strips 204, 206 and a second bottom plate layer B' made up of a sheet of polysilicon or suicide, in what is commonly called a "poly" layer, all connected to the bottom node of the integrated capacitor. The bottom node in this example is the capacitor node that is less susceptible to electronic noise than the top node when the capacitor is used in a particular circuit application. A top plate conductive matrix 212 is covered by the first bottom plate layer B and underlain by the second bottom plate layer B', which forms a partial Faraday shield around the top node.

The first bottom plate layer is made up of strips, rather than a continuous sheet, because of design layout rules familiar to those of skill in the art of IC fabrication. Generally, each metal layer has minimum and maximum metal line widths and minimum separations. Polysilicon and suicide layers typically have different design and process rules than patterned metal layers, which allows forming the bottom plate layer as a contiguous sheet of poly when the poly layer is used. Similarly, large conductive areas can be formed in the semiconductor substrate (e.g., an N-well or a P-well) to form a continuous conductive sheet. In an alternative embodiment, the second bottom plate layer is formed in a conductive well of the substrate. The conductive well is separated from the poly layer by a relatively thin dielectric layer, providing good electrical performance even though the N-well is generally less conductive than a metal layer or poly layer. Using a conductive well to form part of a shield is further desirable because a moat can be formed around the portion of the substrate in which the N-well or P-well is formed, which further isolates the N- or P-well from stray currents. Use of a conductive well in a shield is also desirable because the well is surrounded in a fairly symmetrical fashion by metal, leading to symmetrical current flow through the well portion of the shield.

The conductive strips 204, 206 in the top plate layer B are electrically connected through vias (not shown, see, e.g., via 214) to transverse (i.e., generally orthogonal) conductive strips (e.g., B4) in the lower layer so that interconnection between conductive strips 204, 206 in the metal layer of the first bottom plate layer B is not necessary. Alternatively, conductive cross members (cross-connects between strips in the metal layer) are optionally included in the first bottom plate layer to connect conductive strips in the layer, which improves shielding.

Similarly, a top plate layer T is made up of a plurality of conductive strips 216, 218 connected to the top node of the integrated capacitor. The conductive strips in the top plate layer T are transverse to conductive strips T1 , T2, T3, T4, T5 above the top plate layer T and transverse to conductive strips T6, T7, T8, T9, T10 below the top plate layer, and conductive strips in the top plate layer T are electrically connected to each other through vias and transverse conductive strips above and below the top plate layer T. In some embodiments, the conductive strips (e.g. T1, B1) are made from a minimum-width metal line and are commonly referred to as "conductive filaments" or "metal filaments" and provide high line densities and high lateral capacitance. Lateral capacitance between conductive strips in the plate layers does not contribute to the specific capacitance of the integrated capacitor because the metal strips are connected to the same node, and conductive strips in the plate layers are often wider than minimum metal line width.

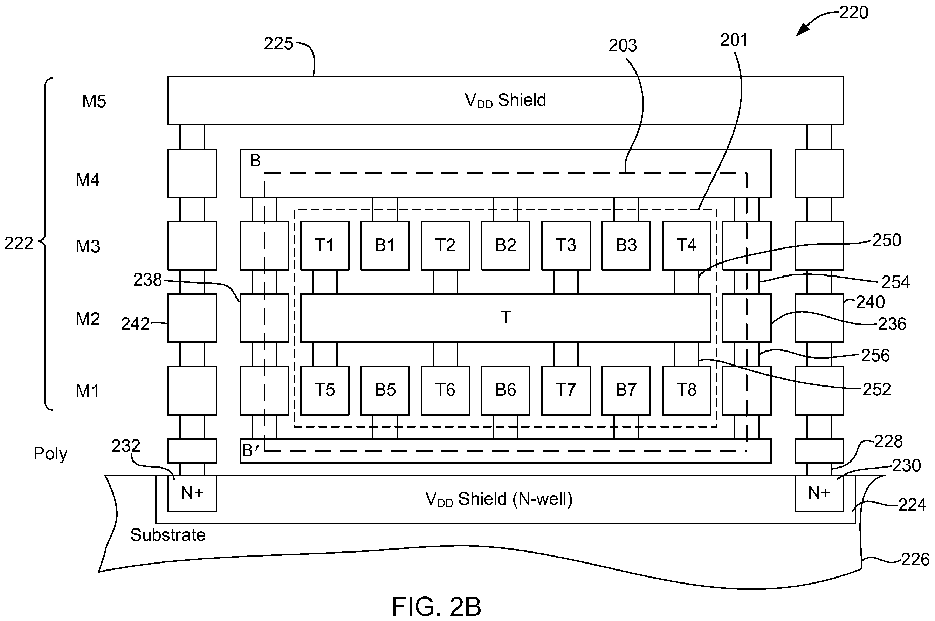

The plate layers B, T, B' do not have alternating conductive strips, but rather all the conductive strips in these layers are connected to either the top node or the bottom node of the integrated capacitor. The configuration of a capacitor according to FIG. 2A provides bottom plates B, B' that shield the conductive elements of the top plate because they are embedded between the first and second bottom plate layers in the IC stack. Conductive curtains (see, FIG. 2B, ref. nums. 236, 238) on the right and left sides of the top plate conductive matrix are formed of vias and metal layers between the first bottom plate B and the second bottom plate B' and extend along a third direction (e.g., the Z direction as illustrated in FIG. 2A) to form essentially a conductive plane (in the plane defined by the Y and Z axes). The bottom plate conductive matrix of the integrated capacitor loosely surrounds the top plate conductive matrix of the integrated capacitor so that the top plate couples with the bottom plate on the top, bottom, right side, and left side. In a further embodiment, additional conductive curtains are optionally added in the plane defined by the X and Z axes to cover (shield) the ends of the top node conductive elements in these planes.

FIG. 2B is a side view of an integrated capacitor 220 in accordance with FIG. 2A. The side view is taken along the direction of the arrow A in FIG. 2A. The integrated capacitor has a core capacitor portion 201 and a shield capacitor portion 203. The shield capacitor portion 203 is basically a bottom node shield that has a first shield layer B formed in the fifth metal layer M5 of a backend stack 222 of an IC that includes metal layers M1, M2, M3, M4, M5 and intervening dielectric layers that have vias (e.g., via 226) extending through the dielectric layers to connect metal layers. The dielectric layers are not shown with hatching for clarity of illustration, as they are well understood by those of skill in the art of IC processing.

Integrated capacitors according to alternative embodiments include additional metal layers. The integrated capacitor includes an optional reference shield, which in this embodiment is a reference shield connected to V_{DD}. The reference shield includes a shield plate 224 made up of a conductive well (Nwell), formed in the semiconductor substrate 226 of the IC, a top shield plate 225 formed in the M5 metal layer, and conductive curtains 240, 242.

The shield capacitor portion 203 forms a conductive sheath around the core capacitor portion 201, which has interleaved top and bottom node conductive filaments that provide high specific lateral capacitance in the M1 and M3 metal layers, and vertical capacitance between the bottom node elements in M1 and M3 and the top node elements in M2, which is adjacent to both M1 and M3. The shield capacitor portion adds additional capacitance by coupling to the top node conductive elements in M1 , M2, and M3. In a typical embodiment, each layer of interleaved filaments will have hundreds of filaments and the lateral coupling between the filaments is a significant portion of the total capacitance of the integrated capacitor.

The second bottom plate layer B' is formed in the poly layer of the IC. In an alternative embodiment, the second bottom plate layer is formed as strips in a metal layer, such as M1 or M2, in a backend stack that has additional metal layers. Utilizing the poly layer for the second bottom plate layer allows a shielded integrated capacitor (without the optional V_{DD} shield) to be formed in a four-metal-layer IC. In an alternative embodiment, a conductive well formed in the semiconductor substrate is used as the second bottom plate layer, allowing an embodiment to be fabricated in three metal layers of an IC, or allowing additional metal layers for increasing the specific capacitance of a capacitor of a given area. The dielectric layer above the substrate and poly layer (not separately shown) is commonly called an inter-layer dielectric ("ILD"), and the conductive element 228 connecting the poly layer to the N+ conductive area 230 of the substrate is commonly called a contact, as opposed to a via. A gate dielectric layer (not separately shown) between the poly and the N-well is typically much thinner than the ILD layer.

FIG. 2B is not drawn to scale. Generally, the thicknesses of the IMD and ILD layers are greater than the spacing between the interleaved conductive strips (e.g., T1 and B1) in the interleaved layers M3 and M1. In an exemplary embodiment, the ILD layer is about 300 nm thick silicon oxide, while the dielectric layer between the poly layer and M1 layer is about 100 nm thick and the higher layers are about 250 nm. The minimum separation between metal traces in a layer is typically much smaller, thus the sidewall capacitance between T1 and B1 , for example, is greater than the vertical capacitance between T1 and B. Similarly, the sidewall capacitance between the ends of the top plate conductive matrix (e.g., T1 , T4, T5, T8, and both ends of T) and the conductive curtains 236, 238; and the end vias 250, 252 and curtain vias 254, 256 (and corresponding vias on other sides) provide additional capacitance that compensates for the lack of interleaving in the M4, M2 and poly layers. As node technology shrinks and the minimum dimension between conductive strips in the interleaved layers decreases, the relative contribution of sidewall capacitance between interleaved metal strips and vias to the overall capacitance increases.

The optional reference shield includes a first shield layer 225 and the shield plate 224 formed in the N-well that are connected through a series of vias, metal, poly, and contacts. The vias, metal, poly, and contacts form a first shield curtain and a second shield curtain that are basically the right and left vertical portions of the reference shield. In a further embodiment, third and fourth conductive curtains of the bottom plate conductive matrix enclose the as-viewed front and back planes of the bottom node shield and core capacitor. These features are not shown for purposes of clarity of illustration, as they would be understood by one of ordinary skill in the art in light of the conductive and shield curtains illustrated in side view.

The reference shield is connected to a stable voltage reference, such as V_{DD} or ground, to reduce coupling of the bottom node to more than one voltage node. For example, the bottom node matrix couples essentially only to the top node and to V_{DD}. Negligible coupling of the other nodes of the IC to the bottom node occurs. Similarly, if the shield were connected to ground instead of V_{DD}, the bottom node would only couple to the top node and ground.

It is generally undesirable for the bottom node to couple to V_{DD} and ground simultaneously because the bottom node would then act as a bridge between ground and V_{DD}, and could couple undesirable switching currents between the two nodes, for example. However, in some embodiments, limited coupling to both V_{DD} and ground is acceptable, particularly if coupling of the bottom node shield to a reference shield is limited to conductive elements connected to an isolated portion of the substrate, or if the ground node is an analog ground node that is reasonably well isolated from a digital ground node.

A gap or similar feature (not shown, see FIG. 1) is provided in the shield to allow circuit connection to the bottom node conductive matrix, and a second gap or similar feature is provided in the shield, and a third gap or similar feature is provided in the bottom plate conductive matrix to allow connection to the top node conductive matrix. In embodiments omitting front and back conductive curtains or shield curtains, electrical connections to the conductive matrices can be brought out in the directions orthogonal to the plane of the illustration sheet, for example. Bottom node shielding can also be brought out along the top node connection to a switch, for example, to further shield the top node.

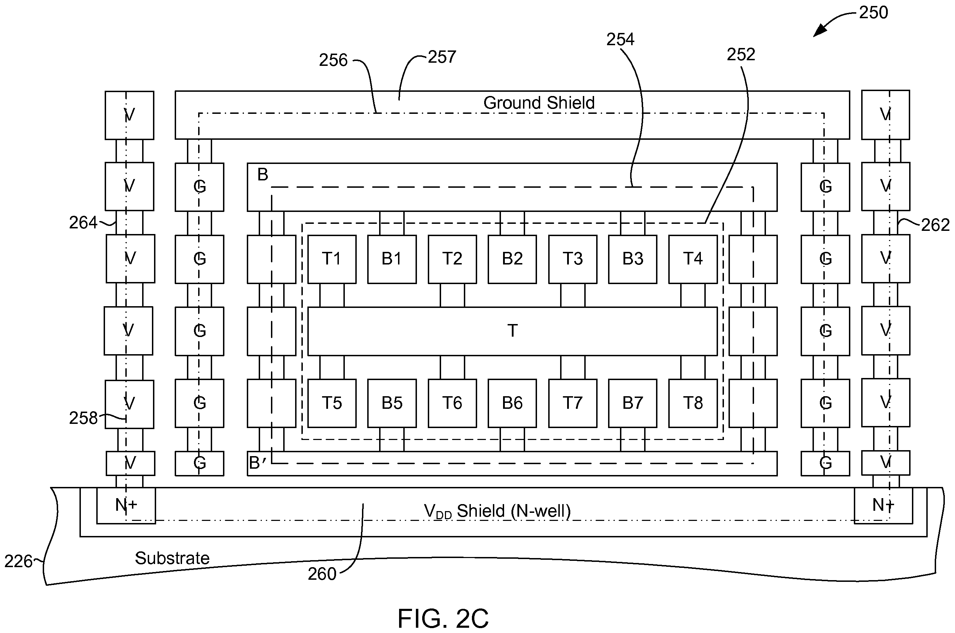

FIG. 2C is a side view of the integrated capacitor 250 with a ground shield 256 (represented as a dashed line). The integrated capacitor 250 includes a core capacitor portion 252 that includes conductive elements (e.g., filaments) within a metal layer (e.g., M1 , M3) alternatively connected to opposite nodes of the capacitor and a shield capacitor portion (bottom node shield) 254. For example, T1 , 12, T3, and T4, alternate with B1 , B2, and B3 in M3 and T5, T6, T7, and T8 alternate with B5, B6, and B7 in M1. Alternating conductive elements in the core capacitor portion 252 provides significant lateral capacitance, which improves as fabrication dimensions are reduced and the conductive elements become closer together. Similar lateral capacitance is obtained between top node elements T1 , 14, 15, 18, and both ends of T and corresponding bottom node elements that form the reference shield. The shield capacitor portion 254 surrounds the core capacitor 252 to form a conductive cage that reduces coupling of the top node to other nodes of the IC.

The integrated capacitor 250 produces good specific capacitance, which is essentially CSIG per unit area of silicon, from both the core capacitor portion 252 and also from coupling between top node elements in the core capacitor portion 252 and the shield capacitor portion 254.

The integrated capacitor includes an optional ground shield 256 that partially surrounds the bottom node shield 254, basically forming a Faraday cup. The ground shield reduces electronic noise generated in the IC that might otherwise couple to the bottom node or top node of the integrated capacitor 250. In a particular embodiment, a reference shield plate 257 is formed in the M5 layer, providing a low-resistance ground path for connecting the ground shield 256 to one or more ground terminals of the IC. In a particular embodiment, the ground shield 256 is connected to the analog ground of the IC, rather than the digital ground to avoid high switching currents and electrical noise that can be present on the digital ground. High switching currents on a digital ground node of an IC are particularly problematic for FPGAs, where entire blocks of the circuit are often switched on and off.

A V_{DD} shield cup 258 (represented as a dashed line) includes a shield plate 260 formed in an N-well in the semiconductor substrate 226. V_{DD} bias is brought to the N-well V_{DD} shield through conductive curtains 262, 264 or alternatively through conductive pillars. Providing the V_{DD} shield cup 258 further shields the top node and the bottom node of the integrated capacitor from electrical noise. In some ICs, the M5 layer might only be a ground shield with no V_{DD} interconnect allowed at M5.

FIG. 2D is a view of an integrated capacitor 270 with a ground shield. The capacitor 270 includes a core capacitor portion 252 and a bottom node shield forming a shield capacitor portion 254 as described above in reference to FIGs. 2A-2C. The shield capacitor portion 254 surrounds the core capacitor portion 252 and isolates the core capacitor portion from electronic noise similarly to how an outer conductive sheath of a cable isolates the inner wires from electronic noise. In a further embodiment, the bottom node shield extends over the ends of the capacitor core not shown in this view (i.e., the ends that are in the plane of the view). In a particular embodiment, the ground shield is connected to analog ground, rather than to digital ground. In a particular embodiment, the portion of the substrate 226 in which the N-well 282 is formed and to which the conductive curtains 274, 276 of the ground shield are connected by P+ regions 278, 280, are formed in a moat (not shown) that isolates the moated portion of the substrate from stray currents in other portions of the substrate. The ground shield and V_{DD} shield forms a shield structure similar to double guard ring shielding, and are particularly desirable to shield the top node of the integrated capacitor in electrically noisy environments. In an embodiment not forming part of the invention, the V_{DD} shield is omitted.

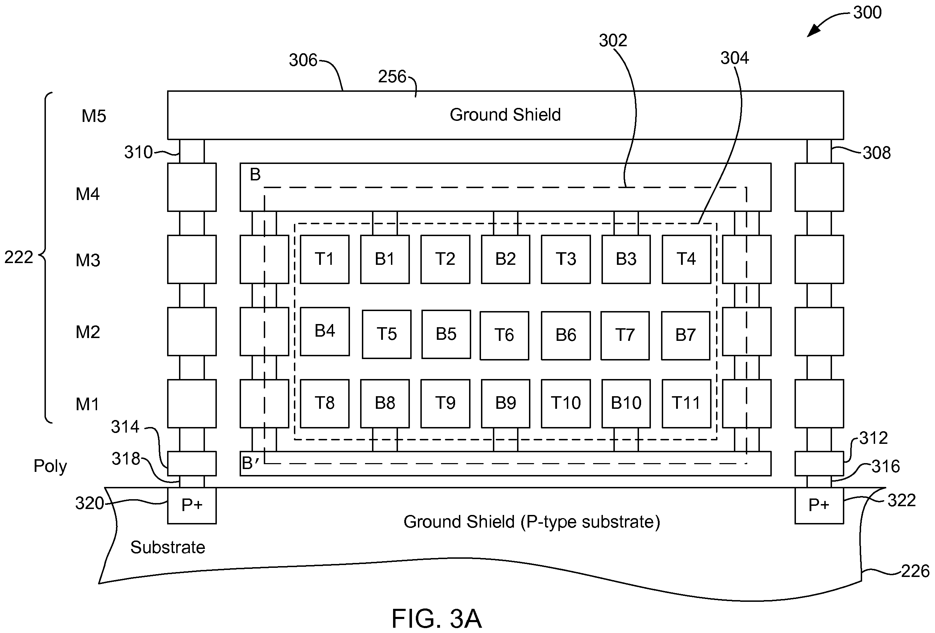

FIG. 3A is a side view of an integrated capacitor 300 according to an alternative example. A core capacitor portion 304 includes conductive elements (e.g., filaments) within a metal layer (e.g., M1 , M2, M3) alternatively connected opposite nodes of the capacitor. For example, T1 , T2, T3, and T4 alternate with B1 , B2, and B3 in M3, T5, T6, and T7 alternate with B4, B5, B6, and B7 in M2, and T8, T9, T10, T11 alternate with B8, B9, and B10 in M1. Top node elements T1 , T4, T8, and T11 also laterally couple with bottom node shield elements. Similarly, B4 vertically couples with T1 and T8, providing vertical capacitance that increases the specific capacitance.

Alternating conductive elements in the core capacitor portion 304 provides lateral capacitance, which improves as fabrication dimensions are reduced and the conductive elements become closer together. While it would be generally desirable that each end element in a metal layer laterally couple with a conductive filament electrically connected to the opposite node of the integrated capacitor, in an actual device there may be hundreds of parallel conductive filaments in each metal layer, and the few row ends that are not opposite polarity may have relatively little detrimental effect.

A ground shield 306 includes ground shield conductive curtains 308, 310, that essentially surround the core capacitor portion 304 and shield capacitor portion 302 of the integrated capacitor. The ground shield conductive curtains 308, 310, include poly elements 312, 314 and contacts 316, 318 to P+ regions 320, 322 in the substrate 226. In an exemplary application, the ground plate 256 in the M5 layer is connected to an analog ground terminal of the IC. The substrate is relatively high resistance; however, the bottom node plate B' is still well-shielded from coupling to other nodes because the silicon below B' is relatively electrically quiet, particularly if that portion of the substrate is formed in a moat and the ground shield typically makes contact with the substrate around the perimeter of the ground shield.

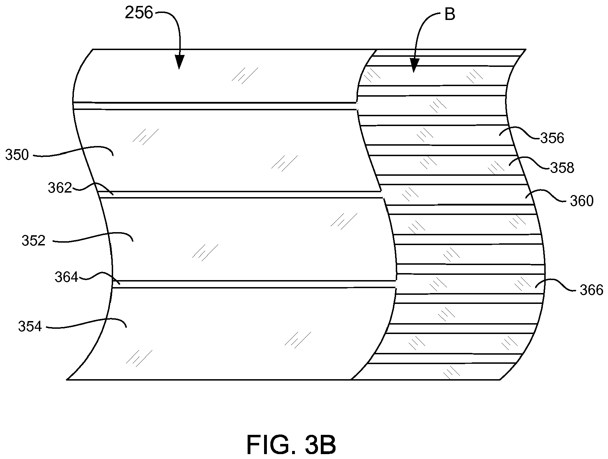

The ground node plate 256 has relatively low resistance to ground because it is a metal layer. In a particular IC application, the M5 layer is used as a ground shielding layer for an analog portion of the IC, and is composed of wide ground strips (see Fig. 3B) with many ground connection points, rather than occasional thin traces, as in other metal layers. It is particularly desirable in some IC applications to maintain the integrity of the analog ground shield layer; however, embodiments that include a V_{DD} shield plate in the analog ground shield layer are useful in many ICs because the V_{DD} shield is connected to a clean (i.e., relatively electrically quiet) supply, which blocks electrical noise from the analog circuitry below from affecting the remainder of the IC, similar to the effect of the ground plane. The small margin between a V_{DD} shield plate and the ground plane in such embodiments provides relatively little area for unwanted electrical noise emissions to occur.

FIG. 3B is a partial cutaway plan view of the M5 and M4 layers showing a portion of the ground plate 256 and underlying bottom node shield plate B of FIG. 3A. The ground plate 256 is made up of wide strips 350, 352, 354 that overlie conductive filaments 356, 358, 360, 366 of the upper bottom node shield plate B. The gaps 362, 364 between the ground plate strips 350, 352, 354 are defined over conductive filaments 360, 366 so that a conductor underlies the gap, which improves shielding of the top node of the integrated capacitor; however, this detail is not essential in all embodiments.

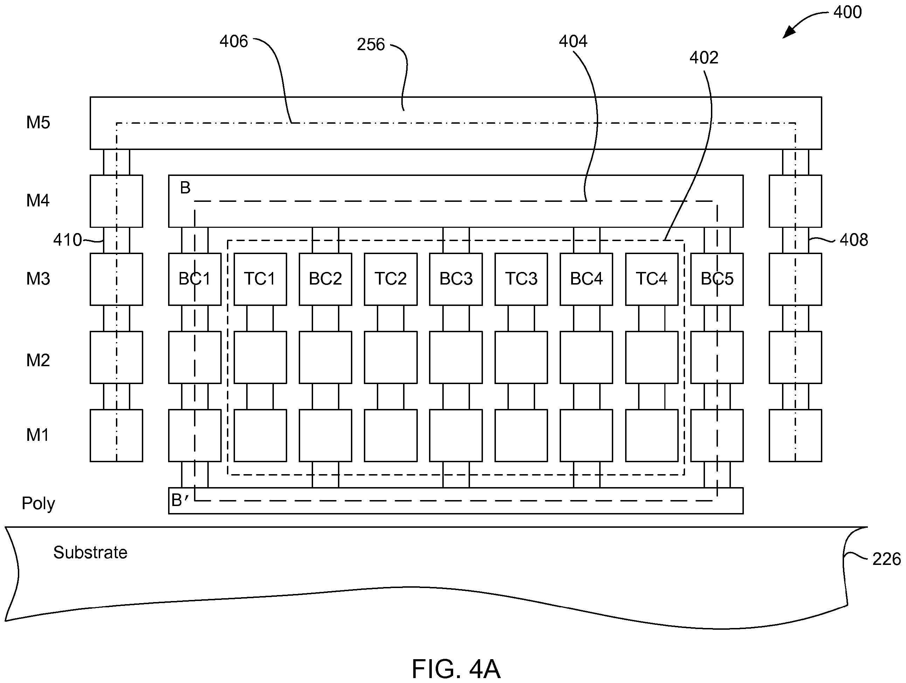

FIG. 4A is side view of an integrated capacitor 400 with a bottom node shield capacitor portion 402 according to yet another example. The bottom node shield capacitor portion 402 sheathes a core capacitor portion 404 having a series of conductive curtains TC1 , TC2, TC3, TC4 electrically connected to the top node of the integrated capacitor 400, interleaved with a series of conductive curtains BC1 , BC2, BC3, BC4, BC5 electrically connected to the bottom node of the integrated capacitor. The conductive curtains are basically conductive filaments formed in successive metal layers connected with conductive vias to form essentially a conductive sheet extending perpendicular to and from the plane of illustration. Electrical connection top node conductive matrix is made through a gap in the bottom node shield, or by bringing a tap (conductive trace) out the end of one of the metal layers. The bottom node conductive curtains BC1 , BC2, BC3, BC4, BC5 are electrically connected through the upper bottom node plate B and lower bottom node plate B' , but alternatively could be connected through one or the other. The conductive curtains BC1 and BC5 connect the upper bottom node plate B with the lower bottom node plate B', which is formed in the poly layer of the IC, and form part of the shield capacitor portion 404 of the integrated capacitor, as well as providing lateral capacitance to the adjacent top node conductive curtains TC1 , TC4 in the core capacitor portion 402. A ground shield cup 406 is formed from a ground shield plate 256 formed in the M5 layer and has conductive curtains Gi, Q2 extending from the ground shield plate 256 toward the substrate 226. In a further embodiment, the conductive curtains extend through the poly layer to the substrate 406 (see, e.g., FIG. 3A).

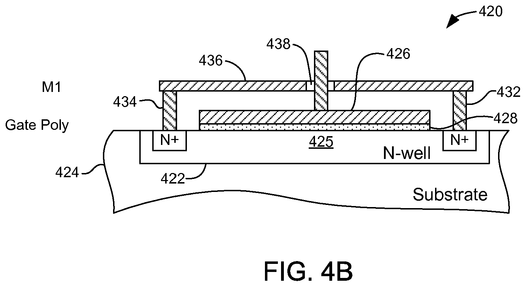

FIG. 4B is a cross section of a shielded integrated thin-dielectric capacitor 420 in an IC according to an example. The thin-dielectric capacitor uses a conductive well 422 in the substrate 424 as a first plate 425 of the capacitor ("substrate plate"). A second plate ("gate layer plate") 426 of the thin-dielectric capacitor is formed in a polysilicon, suicide, or metal layer that is commonly the gate layer of the IC. The gate layer plate 426 is separated from the substrate plate 425 by a thin dielectric layer 428 that commonly forms a gate oxide layer or gate dielectric layer of the IC. Some ICs, such as particular FPGAs, have more than one allowable gate dielectric layer thickness, commonly referred to as thin-oxide, mid-oxide, or thick-oxide. While the thinnest gate dielectric layer would provide the highest specific capacitance, thicker gate dielectric, such as mid-oxide or thick oxide, provides superior reliability and yield at a given operating voltage. The maximum operating voltage for a thin-dielectric capacitor is typically less than the maximum gate voltage for an FET having the same dielectric gate layer. Unlike ILD layers and IMD layers (not shown for clarity of illustration), in which a low dielectric material is generally desired, the gate dielectric material preferably has a relatively high dielectric constant to provide good coupling between the gate and channel of MOSFETs in the IC, which enhances the specific capacitance of the thin-dielectric capacitor 420.

A capacitor shield portion is formed around the gate layer plate 426, which in a particular application is the top node of the integrated capacitor 420. Thus, the shield is a bottom node shield capacitor portion. The shield includes the substrate plate 425, contacts 432, 434, and upper bottom node shield plate 436 formed in a metal layer or a second poly layer of the IC. The contacts are generally spaced around the perimeter of the upper plate 436 to form essentially a Faraday cage around the gate layer plate 426. In an alternative embodiment, the upper plate is formed in a second poly layer that is overlain onto the substrate directly, without the use of contacts.

The substrate plate 425 is an element of both the core capacitor portion (i.e., the core capacitor formed by the substrate plate, gate dielectric layer, and gate layer plate) and the shield capacitor portion. The substrate plate is alternatively formed in a P-well or in the native substrate without a well. The upper bottom node shield plate 436 includes a gap 438 through which electrical contact to the top node (gate layer plate 426) is made, while electrical contact to the substrate can be made through the upper bottom node shield plate 436 and contacts 432, 434. Thus, the top node of the integrated capacitor 420 is shielded from electrical noise.

Since the gate layer plate is formed in the poly layer, it can be a contiguous sheet of conductor and does not have to be formed of stripes or filaments, as in superior metal layers. Similarly, the substrate plate can be a contiguous sheet. The upper bottom node shield plate is typically formed from a series of maximum-width metal lines that are interconnected within the layer to approximate a contiguous sheet. The upper bottom node shield plate contributes substantially to the specific capacitance of the integrated capacitor while also shielding the top node from electrical noise. An estimated specific capacitance for a thin-dielectric capacitor according to an embodiment fabricated in an IC using a thick-oxide of about 250 nm thickness is about 7 fF/µm².

Note that the types of and number of layers described are merely examples, and in some embodiments other suitable layers may be used, and any number of layers may be used. For example, the layers used may depend on the types and numbers of layers that are available in the manufacturing process, and other arrangements will be apparent to those of skill in the art. In general, any suitable layer, and an arbitrary number of layers may be used in accordance with embodiments of the present invention.

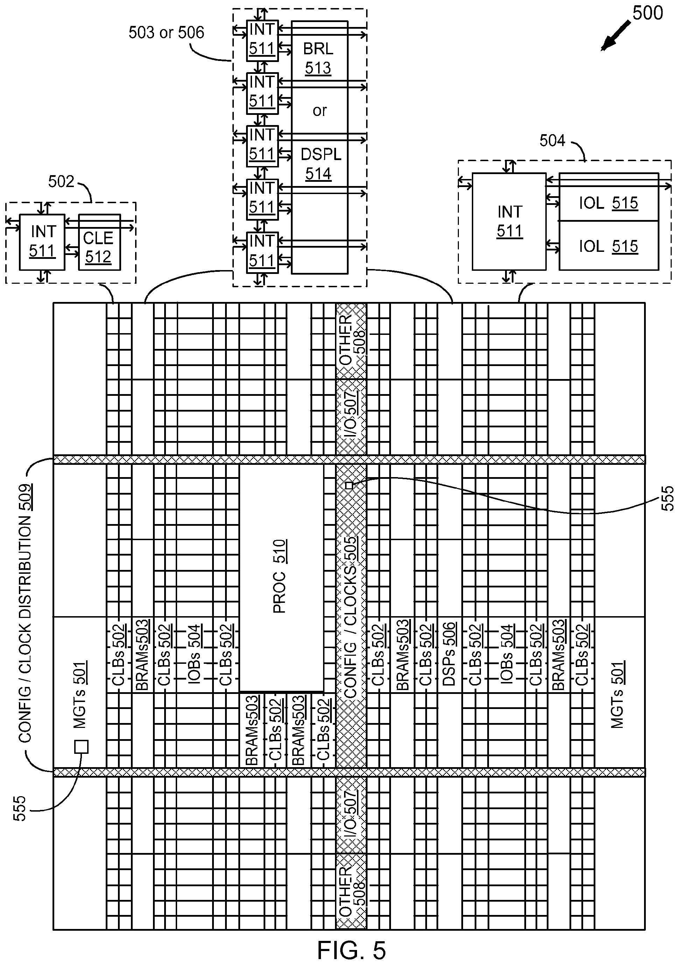

FIG. 5 is a plan view of an example of a FPGA 500 semiconductor device incorporating an integrated capacitor. The FPGA 500 includes CMOS portions in several of the functional blocks, such as in RAM and logic, and is fabricated using a CMOS fabrication process. One or more integrated capacitors 555 according to one or more embodiments of the invention are incorporated in any of several functional blocks of the FPGA, such as a clock circuit 505, a multi-gigabit transceivers 501, or other functional block; within many functional blocks; or within a physical section or segment of the FPGA 500. Integrated capacitors 555 are particularly desirable in applications where one or both terminals of the capacitor are switched, and embodiments including top plate shielding are further desirable in applications wherein the top plate is connected to or switched to a high-impedance or high-gain node of a circuit in the FPGA 500. Capacitors are generally useful in a wide variety of integrated circuits and in a wide variety of applications. For instance, one or more capacitors may be useful for a switched capacitor network, such as in an analog-to-digital converter, or as a decoupling or filtering capacitor for AC signaling (e.g., in an MGT). In general, the capacitor structure described herein may be useful in any application requiring capacitance.

The FPGA architecture includes a large number of different programmable tiles including multi-gigabit transceivers (MGTs 501), configurable logic blocks (CLBs 502), random access memory blocks (BRAMs 503), input/output blocks (lOBs 504), configuration and clocking logic (CONFIG/CLOCKS 505), digital signal processing blocks (DSPs 506), specialized input/output blocks (I/O 507) (e.g., configuration ports and clock ports), and other programmable logic 508 such as digital clock managers, analog-to-digital converters, system monitoring logic, and so forth. Some FPGAs also include dedicated processor blocks (PROC 510).

In some FPGAs, each programmable tile includes a programmable interconnect element (INT 511) having standardized connections to and from a corresponding interconnect element in each adjacent tile. Therefore, the programmable interconnect elements taken together implement the programmable interconnect structure for the illustrated FPGA. The programmable interconnect element (INT 511) also includes the connections to and from the programmable logic element within the same tile, as shown by the examples included at the top of FIG. 5.

For example, a CLB 502 can include a configurable logic element (CLE 512) that can be programmed to implement user logic plus a single programmable interconnect element (INT 511). A BRAM 503 can include a BRAM logic element (BRL 513) in addition to one or more programmable interconnect elements. Typically, the number of interconnect elements included in a tile depends on the height of the tile. In the pictured example, a BRAM tile has the same height as four CLBs, but other numbers (e.g., five) can also be used. A DSP tile 506 can include a DSP logic element (DSPL 514) in addition to an appropriate number of programmable interconnect elements. An IOB 504 can include, for example, two instances of an input/output logic element (IOL 515) in addition to one instance of the programmable interconnect element (INT 511). As will be clear to those of skill in the art, the actual I/O pads connected, for example, to the I/O logic element 515 are manufactured using metal layered above the various illustrated logic blocks, and typically are not confined to the area of the input/output logic element 515. In the pictured example, a columnar area near the center of the die (shown shaded in FIG. 5) is used for configuration, clock, and other control logic.

Some FPGAs utilizing the architecture illustrated in FIG. 5 include additional logic blocks that disrupt the regular columnar structure making up a large part of the FPGA. The additional logic blocks can be programmable blocks and/or dedicated logic. For example, the processor block PROC 510 shown in FIG. 5 spans several columns of CLBs and BRAMs.

Note that FIG. 5 is intended to illustrate only an exemplary FPGA architecture. The numbers of logic blocks in a column, the relative widths of the columns, the number and order of columns, the types of logic blocks included in the columns, the relative sizes of the logic blocks, and the interconnect/logic implementations included at the top of FIG. 5 are purely exemplary. For example, in an actual FPGA more than one adjacent column of CLBs is typically included wherever the CLBs appear, to facilitate the efficient implementation of user logic.

While the foregoing describes exemplary embodiment(s) in accordance with one or more aspects of the present invention, other and further embodiment(s) in accordance with the one or more aspects of the present invention may be devised without departing from the scope thereof, which is determined by the claim(s) that follow. Claim(s) listing steps do not imply any order of the steps. Trademarks are the property of their respective owners

## Claims

1. An integrated circuit ("IC") comprising a capacitor (270), the capacitor (270) comprising:
a core capacitor portion (252) having a first plurality of conductive elements (T1-T4) electrically connected to and forming a first part of a first node of the capacitor (270) formed in a first conductive layer (M3) of the IC and a second plurality of conductive elements (B1-B3) electrically connected to and forming a first part of a second node of the capacitor (270) formed in the first conductive layer (M3), the first plurality of conductive elements (T1-T4) alternating with the second plurality of conductive elements (B1-B3) in the first conductive layer (M3), and a third plurality of conductive elements (T) electrically connected to and forming a second part of the first node formed in a second conductive layer (M2) adjacent to the first conductive layer (M3), at least portions of some of the second plurality of conductive elements (B1-B3) overlying and vertically coupling to at least portions of some of the third plurality of conductive elements (T), wherein the first plurality of conductive elements (T1-T4) comprises a first plurality of conductive strips extending in a first direction, the second plurality of conductive elements (B1-B3) comprises a second plurality of conductive strips extending in the first direction, and the third plurality of conductive elements (T) comprises a third plurality of conductive strips extending in a second direction orthogonal to the first direction;
a shield capacitor portion (254) having a fourth plurality of conductive elements (236, 238) formed in each layer (M1-M4) between a third conductive layer (M4) of the IC and a fourth conductive layer of the IC including at least the first conductive layer (M3) of the IC, the second conductive layer (M2) of the IC, the third conductive layer (M4) of the IC, and the fourth conductive layer of the IC, the first conductive layer (M3) and the second conductive layer (M2) each being between the third conductive layer (M4) and the fourth conductive layer, the shield capacitor portion (254) being electrically connected to and forming a second part of the second node of the capacitor (270) and surrounding the first plurality of conductive elements (T1-T4) and the third plurality of conductive elements (T);
a reference shield (258) electrically connected to a reference node (VDD) of the IC other than the second node of the capacitor (270), the shield capacitor portion (254) being disposed between the reference shield (258) and the core capacitor portion (252), wherein the reference shield (258) includes an N-well (282) of a substrate (226) of the IC, a first conductive curtain extending from the N-well (282), and a second conductive curtain extending from the N-well (282); and
a second reference shield comprising a ground shield (256) and conductive curtains (274, 276) extending from a substrate portion and connected to an analog ground of the IC, the reference shield (258) being disposed between the second reference shield (256) and the shield capacitor portion (254); and
wherein the N-well (282) and the substrate portion are formed in a moat.

2. The integrated circuit of claim 1 wherein the third conductive layer (M4) is a metal layer of the IC and the fourth conductive layer is a poly layer of the IC, the shield capacitor portion (254) including a first node shield plate (B) formed in the metal layer from a plurality of metal strips and a second node shield plate (B') formed in the poly layer.

3. The integrated circuit of claim 1 wherein the shield capacitor portion (254) includes a first node shield plate (B) formed in the third conductive layer (M4) and a second node shield plate (B') formed in the fourth conductive layer and further comprising a first conductive curtain (236) extending from the first node shield plate (B) to the second node shield plate (B') and a second conductive curtain (238) extending from the first node shield plate (B) to the second node shield plate (B').

4. The integrated circuit of claim 1 wherein the reference shield (258) is a first cup shield having an open top.

5. The integrated circuit of claim 1 wherein the first plurality of conductive strips alternate with the second plurality of conductive strips, and wherein the third plurality of conductive strips are adjacent to each other in the second conductive layer (M2), and further comprising a first via (250) to electrically connect a first conductive strip of the first plurality of conductive strips in the first conductive layer (M3) to a second conductive strip of the third plurality of conductive strips in the second conductive layer (M2).

6. The integrated circuit of claim 5 wherein the shield capacitor portion (254) includes a first node shield plate (B) formed in the third conductive layer (M4), the first node shield plate (B) includes a fourth plurality of conductive strips extending along the second direction, the fourth plurality of conductive strips are adjacent to each other in the third conductive layer (M4), and further comprising a second via (214) electrically connecting a third conductive strip of the second plurality of conductive strips in the first conductive layer (M3) to a fourth conductive strip of the fourth plurality of conductive strips in the third conductive layer (M4).

7. The integrated circuit of any one of claims 5 to 6 further comprising a third via electrically connecting a fifth conductive strip of the third plurality of conductive strips to a sixth conductive strip of the first plurality of conductive strips.

8. The integrated circuit of any one of claims 1 to 7 further comprising:
a fifth plurality of conductive elements (T5 to T8) formed in a fifth conductive layer (M1) of the IC disposed between the fourth conductive layer and the second conductive layer (M2) and electrically connected to and forming a third part of the first node, the fourth plurality of conductive elements (240,242) extending along the first direction, and
a sixth plurality of conductive elements (B5-B7) electrically connected to and forming a third part of the second node formed in the fifth conductive layer (M1) extending along the first direction alternating with the fifth plurality of conductive elements in the fifth conductive layer (M1).

9. The integrated circuit of claim 4, wherein the second reference shield (256) includes a second reference shield plate extending across the open top of the first cup shield.

## Patentansprüche

1. Integrierte Schaltung ("IC"), umfassend einen Kondensator (270), wobei der Kondensator (270) Folgendes umfasst:
einen Kernkondensatorabschnitt (252) mit einer ersten Vielzahl von leitenden Elementen (T1-T4), die mit einem ersten Teil eines ersten Knotens des Kondensators (270) elektrisch verbunden sind und diesen bilden, der in einer ersten leitenden Schicht (M3) der IC gebildet ist, und einer zweiten Vielzahl von leitenden Elementen (B1-B3), die mit einem ersten Teil eines zweiten Knotens des Kondensators (270) elektrisch verbunden sind und diesen bilden, der in einer ersten leitenden Schicht (M3) gebildet ist, wobei die erste Vielzahl von leitenden Elementen (T1-T4) im Wechsel mit der zweiten Vielzahl von leitenden Elementen (B1-B3) in der ersten leitenden Schicht (M3) und einer dritten Vielzahl von leitenden Elementen (T) ist, die mit einem zweiten Teil des ersten Knotens elektrisch verbunden sind und diesen bilden, der in einer zweiten leitenden Schicht (M2) benachbart zu der ersten leitenden Schicht (M3) gebildet ist, wobei mindestens Abschnitte von manchen der zweiten Vielzahl von leitenden Elementen (B1-B3) mindestens Abschnitte von manchen der dritten Vielzahl von leitenden Elementen (T) überlagern und vertikal an diese koppeln, wobei die erste Vielzahl von leitenden Elementen (T1-T4) eine erste Vielzahl von leitenden Streifen umfasst, die sich in eine erste Richtung erstrecken, die zweite Vielzahl von leitenden Elementen (B1-B3) eine zweite Vielzahl von leitenden Streifen umfasst, die sich in die erste Richtung erstrecken, und die dritte Vielzahl von leitenden Elementen (T) eine dritte Vielzahl von leitenden Streifen umfasst, die sich in eine zweite Richtung orthogonal zu der ersten Richtung erstrecken;
einen Abschirmungskondensatorabschnitt (254) mit einer vierten Vielzahl von leitenden Elementen (236, 238), die in jeder Schicht (M1-M4) zwischen einer dritten leitenden Schicht (M4) der IC und einer vierten leitenden Schicht der IC einschließlich mindestens der ersten leitenden Schicht (M3) der IC, der zweiten leitenden Schicht (M2) der IC, der dritten leitenden Schicht (M4) der IC und der vierten leitenden Schicht der IC gebildet sind, wobei die erste leitende Schicht (M3) und die zweite leitende Schicht (M2) jeweils zwischen der dritten leitenden Schicht (M4) und der vierten leitenden Schicht sind, wobei der Abschirmungskondensatorabschnitt (254) mit einem zweiten Teil des zweiten Knotens des Kondensators (270) elektrisch verbunden ist und diesen bildet und die erste Vielzahl von leitenden Elementen (T1-T4) und die dritte Vielzahl von leitenden Elementen (T) umgibt;
eine Bezugsabschirmung (258), die mit einem Bezugsknoten (VDD) der IC außer dem zweiten Knoten des Kondensators (270) elektrisch verbunden ist, wobei der Abschirmungskondensatorabschnitt (254) zwischen der Bezugsabschirmung (258) und dem Kernkondensatorabschnitt (252) angeordnet ist, wobei die Bezugsabschirmung (258) eine n-Wanne (282) eines Substrats (226) der IC, einen ersten leitenden Vorhang, der sich von der n-Wanne (282) erstreckt, und einen zweiten leitenden Vorhang beinhaltet, der sich von der n-Wanne (282) erstreckt; und
eine zweite Bezugsabschirmung, die eine Erdungsabschirmung (256) und leitende Vorhänge (274, 276) umfasst, die sich von einem Substratabschnitt erstrecken und mit einer analogen Masse der IC verbunden sind, wobei die Bezugsabschirmung (258) zwischen der zweiten Bezugsabschirmung (256) und dem Abschirmungskondensatorabschnitt (254) angeordnet ist; und
wobei die n-Wanne (282) und der Substratabschnitt in einem Graben gebildet sind.

2. Integrierte Schaltung nach Anspruch 1, wobei die dritte leitende Schicht (M4) eine Metallschicht der IC ist und die vierte leitende Schicht eine Polyschicht der IC ist, wobei der Abschirmungskondensatorabschnitt (254) eine erste Knotenabschirmplatte (B), die in der Metallschicht aus einer Vielzahl von Metallstreifen gebildet sind, und eine zweite Knotenabschirmplatte (B') beinhaltet, die in der Polyschicht gebildet ist.

3. Integrierte Schaltung nach Anspruch 1, wobei der Abschirmungskondensatorabschnitt (254) eine erste Knotenabschirmplatte (B), die in der dritten leitenden Schicht (M4) gebildet ist, und eine zweite Knotenabschirmplatte (B') beinhaltet, die in der vierten leitenden Schicht gebildet ist, und ferner umfassend einen ersten leitenden Vorhang (236), der sich von der ersten Knotenabschirmplatte (B) zu der zweiten Knotenabschirmplatte (B') erstreckt, und einen zweiten leitenden Vorhang (238), der sich von der ersten Knotenabschirmplatte (B) zu der zweiten Knotenabschirmplatte (B') erstreckt.

4. Integrierte Schaltung nach Anspruch 1, wobei die Bezugsabschirmung (258) eine erste Becherabschirmung mit einer offenen Oberseite ist.

5. Integrierte Schaltung nach Anspruch 1, wobei die erste Vielzahl von leitenden Streifen im Wechsel mit der zweiten Vielzahl von leitenden Streifen ist und wobei die dritte Vielzahl von leitenden Streifen zueinander in der zweiten leitenden Schicht (M2) benachbart sind und ferner umfassend eine Durchkontaktierung (250), um einen ersten leitenden Streifen der ersten Vielzahl von leitenden Streifen in der ersten leitenden Schicht (M3) mit einem zweiten leitenden Streifen der dritten Vielzahl von leitenden Streifen in der zweiten leitenden Schicht (M2) elektrisch zu verbinden.

6. Integrierte Schaltung nach Anspruch 5, wobei der Abschirmungskondensatorabschnitt (254) eine erste Knotenabschirmplatte (B) beinhaltet, die in der dritten leitenden Schicht (M4) gebildet ist, wobei die erste Knotenabschirmplatte (B) eine vierte Vielzahl von leitenden Streifen beinhaltet, die sich entlang der zweiten Richtung erstrecken, die vierte Vielzahl von leitenden Streifen benachbart zueinander in der dritten leitenden Schicht (M4) sind, und ferner umfassend eine zweite Durchkontaktierung (214), die einen dritten leitenden Streifen der zweiten Vielzahl von leitenden Streifen in der ersten leitenden Schicht (M3) mit einem vierten leitenden Streifen der vierten Vielzahl von leitenden Streifen in der dritten leitenden Schicht (M4) elektrisch verbindet.

7. Integrierte Schaltung nach einem der Ansprüche 5 bis 6, ferner umfassend eine dritte Durchkontaktierung, die einen fünften leitenden Streifen der dritten Vielzahl von leitenden Streifen mit einem sechsten leitenden Streifen der ersten Vielzahl von leitenden Streifen elektrisch verbindet.

8. Integrierte Schaltung nach einem der Ansprüche 1 bis 7, ferner umfassend:
eine fünfte Vielzahl von leitenden Elementen (T5 bis T8), die in einer fünften leitenden Schicht (M1) der IC gebildet ist, angeordnet zwischen der vierten leitenden Schicht und der zweiten leitenden Schicht (M2) und mit einem dritten Teil des ersten Knotens elektrisch verbunden und diesen bildend, wobei sich die vierte Vielzahl von leitenden Elementen (240, 242) entlang der ersten Richtung erstreckt und
eine sechste Vielzahl von leitenden Elementen (B5-B7), die mit einem dritten Teil des zweiten Knotens elektrisch verbunden sind und diesen bilden, der in der fünften leitenden Schicht (M1) gebildet ist, die sich entlang der ersten Richtung im Wechsel mit der fünften Vielzahl von leitenden Elementen in der fünften leitenden Schicht (M1) erstrecken.

9. Integrierte Schaltung nach Anspruch 4, wobei die zweite Bezugsabschirmung (256) eine zweite Bezugsabschirmungsplatte beinhaltet, sie sich über die offene Oberseite der ersten Becherabschirmung erstreckt.

## Revendications

1. Circuit intégré (« IC ») comprenant un condensateur (270), le condensateur (270) comprenant :
une partie de condensateur centrale (252) présentant une première pluralité d'éléments conducteurs (T1-T4) connectés électriquement à, et formant, une première partie d'un premier nœud du condensateur (270) formé dans une première couche conductrice (M3) du circuit IC, et une deuxième pluralité d'éléments conducteurs (B1-B3) connectés électriquement à, et formant, une première partie d'un second nœud du condensateur (270) formé dans la première couche conductrice (M3), la première pluralité d'éléments conducteurs (T1-T4) alternant avec la deuxième pluralité d'éléments conducteurs (B1-B3) dans la première couche conductrice (M3), et présentant une troisième pluralité d'éléments conducteurs (T) connectés électriquement à, et formant, une deuxième partie du premier nœud formé dans une deuxième couche conductrice (M2) adjacente à la première couche conductrice (M3), dans lequel au moins des parties de certains éléments de la deuxième pluralité d'éléments conducteurs (B1-B3) recouvrent et se couplent verticalement avec au moins des parties de certains éléments de la troisième pluralité d'éléments conducteurs (T), dans lequel la première pluralité d'éléments conducteurs (T1-T4) comprend une première pluralité de bandes conductrices s'étendant dans une première direction, la deuxième pluralité d'éléments conducteurs (B1-B3) comprend une deuxième pluralité de bandes conductrices s'étendant dans la première direction, et la troisième pluralité d'éléments conducteurs (T) comprend une troisième pluralité de bandes conductrices s'étendant dans une seconde direction orthogonale à la première direction ;
une partie de condensateur de blindage (254) présentant une quatrième pluralité d'éléments conducteurs (236, 238) formés dans chaque couche conductrice (M1-M4) entre une troisième couche conductrice (M4) du circuit IC et une quatrième couche conductrice du circuit IC incluant au moins la première couche conductrice (M3) du circuit IC, la deuxième couche conductrice (M2) du circuit IC, la troisième couche conductrice (M4) du circuit IC, et la quatrième couche conductrice du circuit IC, la première couche conductrice (M3) et la deuxième couche conductrice (M2) se trouvant chacune entre la troisième couche conductrice (M4) et la quatrième couche conductrice, la partie de condensateur de blindage (254) étant connectée électriquement à, et formant, une deuxième partie du second nœud du condensateur (270) et entourant la première pluralité d'éléments conducteurs (T1-T4) et la troisième pluralité d'éléments conducteurs (T);
un blindage de référence (258) connecté électriquement à un nœud de référence (VDD) du circuit IC, distinct du second nœud du condensateur (270), la partie de condensateur de blindage (254) étant disposée entre le blindage de référence (258) et la partie de condensateur centrale (252), dans lequel le blindage de référence (258) comprend un puits N (282) d'un substrat (226) du circuit IC, un premier rideau conducteur s'étendant à partir du puits N (282), et un second rideau conducteur s'étendant à partir du puits N (282) ; et
un second blindage de référence comprenant un blindage de masse (256) et des rideaux conducteurs (274, 276) s'étendant à partir d'une partie de substrat et connectés à une masse analogique du circuit IC, le blindage de référence (258) étant disposé entre le second blindage de référence (256) et la partie de condensateur de blindage (254) ; et
dans lequel le puits N (282) et la partie de substrat sont formés dans une cavité.

2. Circuit intégré selon la revendication 1, dans lequel la troisième couche conductrice (M4) est une couche métallique du circuit IC et la quatrième couche conductrice est une couche de polysilicium du circuit IC, la partie de condensateur de blindage (254) incluant une première plaque de blindage de nœud (B) formée dans la couche métallique à partir d'une pluralité de bandes métalliques et une seconde plaque de blindage de nœud (B') formée dans la couche de polysilicium.

3. Circuit intégré selon la revendication 1, dans lequel la partie de condensateur de blindage (254) inclut une première plaque de blindage de nœud (B) formée dans la troisième couche conductrice (M4), et une seconde plaque de blindage de nœud (B') formée dans la quatrième couche conductrice, et comprenant en outre un premier rideau conducteur (236) s'étendant de la première plaque de blindage de nœud (B) à la seconde plaque de blindage de nœud (B'), et un second rideau conducteur (238) s'étendant de la première plaque de blindage de nœud (B) à la seconde plaque de blindage de nœud (B').

4. Circuit intégré selon la revendication 1, dans lequel le blindage de référence (258) est un premier blindage en coupelle présentant une partie supérieure ouverte.

5. Circuit intégré selon la revendication 1, dans lequel la première pluralité de bandes conductrices alterne avec la deuxième pluralité de bandes conductrices, et dans lequel les bandes de la troisième pluralité de bandes conductrices sont mutuellement adjacentes dans la deuxième couche conductrice (M2), et comprenant en outre un premier trou d'interconnexion (250) pour connecter électriquement une première bande conductrice de la première pluralité de bandes conductrices dans la première couche conductrice (M3) à une seconde bande conductrice de la troisième pluralité de bandes conductrices dans la deuxième couche conductrice (M2).

6. Circuit intégré selon la revendication 5, dans lequel la partie de condensateur de blindage (254) inclut une première plaque de blindage de nœud (B) formée dans la troisième couche conductrice (M4), dans lequel la première plaque de blindage de nœud (B) inclut une quatrième pluralité de bandes conductrices s'étendant le long de la seconde direction, dans lequel les bandes conductrices de la quatrième pluralité de bandes conductrices sont mutuellement adjacentes dans la troisième couche conductrice (M4), et comprenant en outre un deuxième trou d'interconnexion (214) connectant électriquement une troisième bande conductrice de la deuxième pluralité de bandes conductrices dans la première couche conductrice (M3) à une quatrième bande conductrice de la quatrième pluralité de bandes conductrices dans la troisième couche conductrice (M4).

7. Circuit intégré selon l'une quelconque des revendications 5 à 6, comprenant en outre un troisième trou d'interconnexion connectant électriquement une cinquième bande conductrice de la troisième pluralité de bandes conductrices à une sixième bande conductrice de la première pluralité de bandes conductrices.

8. Circuit intégré selon l'une quelconque des revendications 1 à 7, comprenant en outre :
une cinquième pluralité d'éléments conducteurs (T5 à T8) formés dans une cinquième couche conductrice (M1) du circuit IC disposée entre la quatrième couche conductrice et la deuxième couche conductrice (M2) et connectée électriquement à, et formant, une troisième partie du premier nœud, la quatrième pluralité d'éléments conducteurs (240, 242) s'étendant le long de la première direction ; et
une sixième pluralité d'éléments conducteurs (B5-B7) connectés électriquement à, et formant, une troisième partie du second nœud formé dans la cinquième couche conductrice (M1) s'étendant le long de la première direction alternant avec la cinquième pluralité d'éléments conducteurs dans la cinquième couche conductrice (M1).

9. Circuit intégré selon la revendication 4, dans lequel le second blindage de référence (256) inclut une seconde plaque de blindage de référence s'étendant à travers la partie supérieure ouverte du premier blindage à coupelle.
